# EUROPEAN PATENT SPECIFICATION

(11) **EP 2 451 030 B1**
(45) Date of publication and mention of the grant of the patent: **30.12.2020**
(21) Application number: 10830008.8
(22) Date of filing: 12.11.2010
(51) Int. Cl.: H01S 3/067, H01S 3/0941, H01S 5/042, H01S 5/062, H01S 3/00, H01S 3/094, B23K 26/04

(54) **LASER PROCESSING DEVICE AND LASER PROCESSING METHOD**
LASERBEARBEITUNGSVORRICHTUNG UND LASERBEARBEITUNGSVERFAHREN
DISPOSITIF ET PROCÉDÉ D'USINAGE LASER

(30) Priority: 16.11.2009 JP 2009260829
(43) Date of publication of application: 09.05.2012
(73) Proprietor: Omron Corporation, Kyoto-shi, Kyoto 600-8530 (JP)
(72) Inventor: OGAKI, Tatsuo, Kyoto 600-8530 (JP); FUKUI, Hiroshi, Kyoto 600-8530 (JP); OKABAYASHI, Takafumi, Kyoto 600-8530 (JP); ISHIZU, Yuichi, Kyoto 600-8530 (JP)
(74) Representative: Horn Kleimann Waitzhofer Patentanwälte PartG mbB
(86) International application number: PCT/JP2010/070176
(87) International publication number: WO 2011/059049

(56) References cited:
- WO-A1-2009/052847
- GB-A- 2 424 311
- JP-A- 2003 086 888
- JP-A- 2003 149 613
- JP-A- 2003 218 455
- JP-A- 2004 337 970
- JP-A- 2009 066 625
- US-A- 5 946 334
- US-A1- 2005 225 846
- US-A1- 2006 126 477
- US-A1- 2009 086 773
- US-A1- 2010 189 139
- BABUSHKIN A ET AL: "Multi-kilowatt peak power pulsed fiber laser with precise computer controlled pulse duration for materials processing", PROCEEDINGS OF SPIE - INTERNATIONAL SOCIETY FOR OPTICAL ENGINEERING, S P I E - INTERNATIONAL SOCIETY FOR OPTICAL ENGINEERING, US, vol. 5709, 24 January 2005 (2005-01-24), pages 98-102, XP002346511, ISSN: 0277-786X, DOI: 10.1117/12.593987

## Description

### TECHNICAL FIELD

The present invention relates to a laser processing device and a laser processing method, and more specifically to the generation of laser light by a laser processing device.

### RELATED ART

Laser processing devices are widely used for various kinds of processing. For such purposes as increasing the processing efficiency of laser processing devices, methods have been proposed, in which the laser light emitted by the laser processing devices is multi-pulsed.

For example, Patent Document 1 (JP H11-221684A (Japanese Patent No. 4132172), Patent Document 2 (JP H05-57464A (Japanese Patent No. 2848052), Patent Document 3 (JP 2005-511314A) each disclose a method in which a single light pulse is divided into a plurality of light pulses, and after letting the plurality of light pulses pass through light paths of different lengths, the light pulses are combined. Letting the light path length for the plurality of light pulses differ creates time intervals corresponding to the difference of the light path lengths among the plurality of light pulses. Thus, it is possible to generate a pulse train (multi-pulse) from a single optical pulse.

### RELATED ART DOCUMENTS

### PATENT DOCUMENTS

Patent Document 1: JP H11-221684A (Japanese Patent No. 4132172)
Patent Document 2: JP H05-57464A (Japanese Patent No. 2848052)
Patent Document 3: JP 2005-511314A

### SUMMARY OF THE INVENTION

### PROBLEM TO BE SOLVED BY THE INVENTION

However, the methods for generating a pulse train described in the above-noted Patent Documents 1 to 3 leave room for improvement with regard to the following aspects:

First of all, since light paths of different lengths need to be provided for a plurality of light pulses, the laser processing device becomes large. For example, in order to provide a time interval of 10 ns between two light pulses, the difference between the light path lengths needs to be 3 m.

Next, in order to combine a plurality of light pulses, it is necessary to adjust the light axes of optical components such that the light axes of the plurality of light pulses match perfectly. However, since it is necessary to adjust the light axes of a large number of optical components, the adjustment is very labor-intensive. Furthermore, there is the possibility that the optical axes of the optical components are affected by the surrounding temperature or by oscillations. In order to prevent shifts in the optical axes of the optical components, the laser processing device needs to have a robust structure that can withstand changes in the environment.

Furthermore, due to limitations in the configuration of the device, it is difficult to change the conditions of the light pulses included in the pulse train. For example, in order to change the time interval between two light pulses, the difference between the light path lengths of the light pulses needs to be changed. However, in order to make it possible to change the light path lengths, a very complex mechanism is necessary.

Since a single light pulse is divided into a plurality of light pulses corresponding to the number of light paths, the number of light pulses included in the pulse train is fixed. Also the ratio of the powers among the plurality of light pulses is fixed.

As noted above, in a conventional laser processing device, the degree of freedom relating to the control of the pulse train that is output from the laser processing device is low. Therefore, there is the possibility that the processing desired by the user cannot be realized with the laser processing device.

It is thus an object of the present invention to provide a laser processing device and a laser processing method using this laser processing device, with which laser light (a pulse train) for desired processing can be output while preventing the device from becoming large and the configuration from becoming complex.

US 2009/086773 A1, or US 2005/225846 A1, discloses a laser processing device comprising a seed light source emitting seed light, an excitation light source emitting excitation light, and a light-amplifying fiber arranged such that the seed light is amplified by coupling the seed light and the excitation light into it, wherein the seed light source repeatedly generates, as the seed light, pulse trains including a plurality of light pulses.

### MEANS FOR SOLVING THE PROBLEMS

Summarizing the present invention, a laser processing device comprises a seed light source emitting seed light, an excitation light source emitting excitation light, and a light-amplifying fiber arranged such that the seed light is amplified by coupling the seed light and the excitation light into it. The seed light source repeatedly generates, as the seed light, pulse trains including a plurality of light pulses. A time interval between the plurality of light pulses is shorter than an interval between the pulse trains. At least one of a number, a pulse width, an amplitude and an interval of the light pulses is variable. One aspect of the present invention relates to a laser processing device as defined in claim 1. Embodiments of the laser processing device in accordance with the invention are set out in the dependent claims.

The seed light source generates the pulse trains with a predetermined period. The seed light source comprises a semiconductor laser. The laser processing device further comprises a drive circuit driving the semiconductor laser using digital data defining the waveform of the pulse train.

It is preferable that the plurality of light pulses are irradiated at substantially the same location of a processing object.

It is preferable that the pulse width of the light pulses is not greater than 20 ns.

It is preferable that the drive circuit that comprises a digital/analog converter that converts the digital data into an analog signal, comprises an amplifier that amplifies the analog signal from the digital/analog converter, and a transistor that controls the drive current that is supplied to the semiconductor laser in response to the analog signal amplified by the amplifier.

It is preferable that the drive circuit comprises a digital/analog converter that converts the digital data into a current signal, a current/voltage converter that converts the current signal into a voltage signal, a bias voltage source that generates a bias voltage, a differential amplifier that generates a signal corresponding to a difference between a voltage of the voltage signal and the bias voltage, and a transistor that controls the drive current that is supplied to the semiconductor laser in response to the signal that is generated by the differential amplifier.

It is preferable that the bias voltage source generates the bias voltage corresponding to the data input into the bias voltage source.

Another aspect of the present invention relates to a laser processing method as defined in claim 7, with a laser processing device comprising a seed light source emitting seed light, an excitation light source emitting excitation light, a light-amplifying fiber arranged such that the seed light is amplified by coupling the seed light and the excitation light into it, and a scanning mechanism for scanning with the light emitted from the light-amplifying fiber is provided. The laser processing method comprises a step of repeatedly generating, as the seed light, pulse trains comprising a plurality of light pulses, from the seed light source, and a step of forming a desired pattern on a surface of a processing object, by irradiating the processing object with the emission light from the light-amplifying fiber using the scanning mechanism. A time interval between the plurality of light pulses is shorter than an interval between the pulse trains. A number, a pulse width, an amplitude and an interval of the light pulses is variable. In the step of generating the seed light, the interval of the light pulses is changed depending on the processing location of the processing object.

### EFFECTS OF THE INVENTION

In accordance with the present invention, a laser processing device can be realized with which laser light (a pulse train) for desired processing can be output while preventing the device from becoming large and the configuration from becoming complex.

### BRIEF DESCRIPTION OF THE DRAWINGS

- Fig. 1: is a diagram showing a configuration example of a laser processing device according to an embodiment of the present invention.
- Fig. 2A: is a cross-sectional view of a single-clad fiber that is an example of the optical fiber 1, 8 according to one embodiment.
- Fig. 2B: is a cross-sectional view of a single-clad fiber that is an example of the optical fiber 1, 8 according to one embodiment.
- Fig. 2C: is a cross-sectional view of a double-clad fiber that is an example of the optical fiber 1, 8 according to one embodiment.
- Fig. 2D: is a cross-sectional view of a double-clad fiber that is an example of the optical fiber 1, 8 according to one embodiment.
- Fig. 3: is a diagram illustrating a waveform of the seed light according to one embodiment.
- Fig. 4: is a diagram showing an example of the configuration of the driver 21 driving the seed LD 2 shown in Fig. 1.
- Fig. 5A: is a diagram showing the output timing of the digital data that is output from the FPGA 42 shown in Fig. 4.
- Fig. 5B: is a diagram showing the output timing of the digital data that is output from the FPGA 42 shown in Fig. 4.
- Fig. 5C: is a waveform diagram of the drive current I_{LD} shown in Fig. 4.
- Fig. 6: is a diagram showing the waveform of the seed light that is output from the seed LD by supplying the drive current I_{LD} having the waveform shown in Fig. 5C to the seed LD.
- Fig. 7: is a diagram showing a waveform of the seed light where the peak of the plurality of light pulses constituting a pulse train is controlled to be constant.
- Fig. 8: is a diagram showing the power waveform of the emission light (pulse train) for the case that the degree of amplification of the light-amplifying fiber is small.
- Fig. 9: is a diagram showing the power waveform of the emission light (pulse train) for the case that the degree of amplification of the light-amplifying fiber is medium.
- Fig. 10: is a diagram showing the power waveform of the emission light (pulse train) for the case that the degree of amplification of the light-amplifying fiber is large.
- Fig. 11: is a diagram showing the power waveform of the emission light (pulse train) for the case that the seed light having the waveform shown in Fig. 9 is amplified.
- Fig. 12: is a diagram showing another example of a configuration of a driver 21 driving the seed LD 2 shown in Fig. 1.
- Fig. 13: is a waveform diagram of the voltage Vin shown in Fig. 12.
- Fig. 14: is a waveform diagram of the voltage V_{LD} that is controlled by the driver 21 shown in Fig. 12.
- Fig. 15: is a waveform diagram of the current I_{LD} for the case that the voltage Vbias is zero and the period of the voltage V_{LD} is short.
- Fig. 16: is a waveform diagram of the current I_{LD} for the case that the voltage Vbias is set to a predetermined value.
- Fig. 17: is a diagram showing yet another example of a configuration of the driver 21 driving the seed LD 2.
- Fig. 18: is a diagram illustrating the operation of the driver 21 having the configuration shown in Fig. 17.
- Fig. 19: is a diagram showing an example of the result of a processing experiment performed while changing only the pulse interval tp.
- Fig. 20: is a diagram showing an example of the processing that can be realized with the laser processing device according to an embodiment of the present invention.
- Fig. 21A: is a diagram showing, as a graph, the relationship between the pulse width of the seed light and the peak power (the SBS threshold) of the amplified light when the seed light is amplified as much as possible without generating stimulated Brillouin scattering (SBS).
- Fig. 21B: is a diagram showing, as a table, the relationship between the pulse width of the amplified light, the peak power, and the drive current of the excitation LDs.
- Fig. 22: is a diagram showing the result of printing on the surface of metal with light pulses emitted from a laser amplifier, during the occurrence of SBS.
- Fig. 23: is a diagram showing the result of printing on a metal surface with laser light (pulse train) emitted from the laser processing device under the condition that there is no SBS, in accordance with one embodiment.

### EMDODIMENTS OF THE INVENTION

In the following, embodiments of the invention are explained with reference to the accompanying drawings. It should be noted that in the drawings, identical or corresponding portions have been assigned the same reference numerals, and their explanation is not repeated.

Throughout this specification, the terms "pulse train" and "multi-pulse" refer to a plurality of light pulses arranged in succession on the time axis over a given time interval.

Furthermore, throughout this specification, the term "LD" refers to a semiconductor laser.

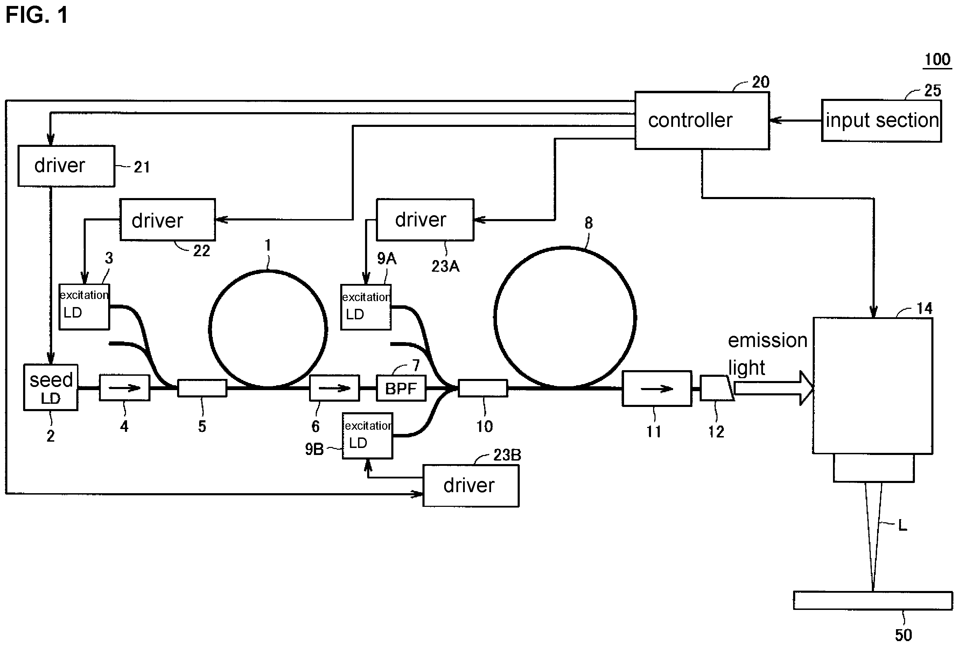

Fig. 1 is a diagram showing a configuration example of a laser processing device according to an embodiment of the present invention. As shown in Fig. 1, a laser processing device 100 includes a laser amplifier of the two-stage amplification type. More specifically, the laser processing device 100 includes optical fibers 1 and 8, a seed LD 2, excitation LDs 3, 9A and 9B, isolators 4, 6 and 11, a band-pass filter (BPF) 7, couplers 5 and 10, an end cap 12, and drivers 21, 22, 23A and 23B. These elements constitute a laser amplifier. The laser processing device 100 further includes a laser beam scanning mechanism 14, a controller 20 and an input section 25.

The optical fibers 1 and 8 are light-amplifying fibers. In the present embodiment, the optical fibers 1 and 8 are quartz fibers whose principal component is quartz, but they also may be plastic light-amplifying fibers.

The optical fibers 1 and 8 include a core that is doped with a rare-earth element serving as a light-amplifying component, and a cladding that is provided around the core. There is no particular limitation to the rare-earth element with which the core is doped, and it may be for example Er (erbium), Yb (ytterbium), Nd (neodymium) or the like. The following explanations relate to the case that the rare-earth element is Yb.

The optical fibers 1 and 8 may be for example single-clad fibers, in which a single cladding layer is provided around the core, or double-clad fibers, in which two cladding layers are provided around the core. Moreover, the optical fibers 1 and 8 may be optical fibers of the same structure (for example, single-clad fibers) or a combination of optical fibers of different structures (for example, single-clad fiber and double-clad fiber).

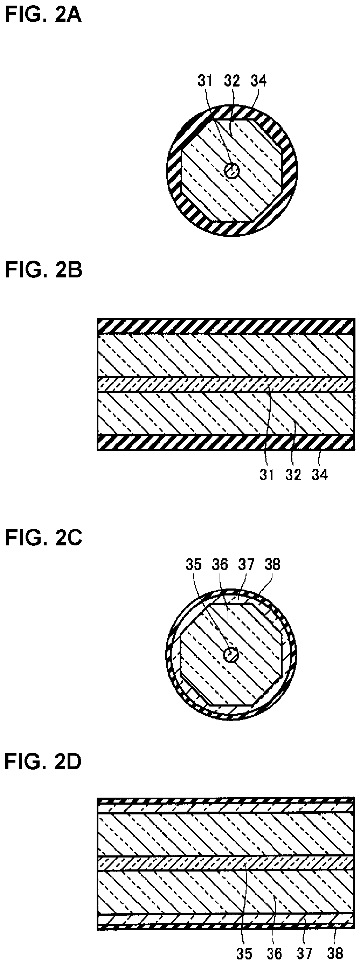

Figs. 2A to 2D are diagrams that show an example of the structure of the optical fibers 1 and 8 according to the present embodiment. Figs. 2A and 2B are cross-sectional views of an example of a single-clad fiber, and respectively show a cross-section in a direction vertical to and a direction parallel to the direction in which the fiber extends.

As shown in Figs. 2A and 2B, a single-clad fiber includes a core 31 that is doped with a rare-earth element, and a cladding 32, provided around the core 31, whose refractive index is lower than that of the core 31. The outer surface of the cladding 32 is covered by a jacket 34.

Figs. 2C and 2D are cross-sectional views that show an example of a double-clad fiber, and respectively show a cross-section in a direction vertical to and a direction parallel to the direction in which the fiber extends.

As shown in Figs. 2C and 2D, a double-clad fiber includes a core 35 that is doped with a rare-earth element, a first cladding 36 provided around the core 35 whose refractive index is lower than that of the core 35, and a second cladding 37 provided around the first cladding 36 whose refractive index is lower than that of the first cladding 36. The outer surface of the second cladding 37 is covered by a jacket 38.

Returning to Fig. 1, the seed LD 2 is a laser light source that emits seed light. The wavelength of the seed light is selected from the range of 1000 to 1100 nm, for example. By repeatedly applying a pulsed current to the seed LD 2, the driver 21 pulse-drives the seed LD 2. That is to say, pulsed seed light is emitted from the seed LD 2.

The seed light emitted from the seed LD 2 passes through the isolator 4. The isolator 4 transmits light only in one direction, and realizes the functionality of blocking light that is incident on it in the direction opposite to that light. In the present embodiment, the isolator 4 transmits the seed light from the seed LD 2 and blocks returning light that returns from the optical fiber 1. Thus, it can be prevented that the returning light from the optical fiber 1 is incident on the seed LD 2. If returning light from the optical fiber 1 were incident on the seed LD 2, there would be the risk that the seed LD 2 is damaged, but by providing the isolator 4, this problem can be prevented.

The excitation LD 3 is an excitation light-source that emits excitation light for exciting the rare-earth atoms with which the core of the optical fiber 1 is doped. If the rare-earth element is Yb, then the wavelength of the excitation light is 940 ± 10 nm, for example. The driver 22 CW-drives (continually drives) the excitation LD 3.

The coupler 5 couples the seed light from the seed LD 2 and the excitation light from the excitation LD 3 into the optical fiber 1.

The excitation light coupled into the optical fiber 1 is absorbed by the rare-earth atoms included in the core, so that these atoms are excited. When the seed light from the seed LD 2 is propagated along the core of the optical fiber 1, the excited atoms cause stimulated emission due to the seed light, thus amplifying the seed light.

If the optical fiber 1 is a single-cladding fiber, the seed light and the excitation light are both incident on the core. If, on the other hand, the optical fiber 1 is a double-cladding fiber, then the seed light is incident on the core, and the excitation light is incident on the first cladding. The first cladding of a double-cladding fiber functions as a waveguide for excitation light. By the process of propagating with the first cladding excitation light incident on the first cladding, the rare-earth elements in the core are excited by the modes passing through the core.

The isolator 6 transmits the seed light (light pulses) amplified by the optical fiber 1 and emitted from the optical fiber 1, and blocks the light from returning into the optical fiber 1.

The band-pass filter 7 passes light of a wavelength band including the peak wavelength of the light pulses that are output from the optical fiber 1, and removes light of a wavelength band that is different from that wavelength band.

The excitation LDs 9A and 9B emit excitation light in order to excite the rare-earth atoms in the core of the optical fiber 8. The drivers 23A and 23B CW-drive the excitation LDs 9A and 9B, respectively.

With the configuration shown in Fig. 1, the number of first-stage excitation LDs is one, and the number of second-stage excitation LDs is two, but the number of excitation LDs is not limited to this.

The coupler 10 couples the light pulses that have passed the band-pass filter 7 and the excitation light from the excitation LDs 9A and 9B into the optical fiber 8. Through the same light-amplifying operation as with the optical fiber 1, the light pulses coupled into the optical fiber 8 are amplified.

The isolator 11 passes the light pulses emitted from the optical fiber 8 and blocks the light from returning into the optical fiber 8. The light pulses passing the isolator 11 are emitted into the atmosphere from the end face of the optical fiber pertaining to the isolator 11. The end cap 12 is provided in order to prevent damage to the interface between the end face of the optical fiber and the atmosphere when light pulses with a high peak power are emitted from the optical fiber into the atmosphere.

The laser beam scanning mechanism 14 is for scanning the emission light from the laser amplifier with respect to two dimensions. Although not shown in the drawings, the laser beam scanning mechanism 14 may include, for example, a collimating lens for adjusting the diameter of the laser beam emitted from the end cap 12 to a predetermined size, a galvano scanner for scanning the laser beam that has passed through the collimating lens with respect to two dimensions over the surface of a processing object 50 an fθ lens for focusing the laser beam. By scanning the laser light L with respect to two dimensions over the surface of the processing object 50, the surface of the processing object 50, which is made of metal or the like as a raw material, can be processed. For example, information such as text or graphics or the like may be impressed (marked) on the surface of the processing object 50.

The controller 20 controls the operation of the laser processing device 100 by comprehensively controlling the drivers 21, 22, 23A and 23B and the laser beam scanning mechanism 14. An input section 25 receives information (such as text or symbols to be printed on the surface of the processing object 50) from a user, for example, and sends the received information to the controller 20. Based on the information from the input section 25, the controller 20 controls the operation start and the operation end of the drivers 21, 22, 23A and 23B, and controls the operation of the laser beam scanning mechanism 14 while the drivers 21, 22, 23A and 23B are operating (or in other words, while light is emitted from the laser amplifier).

The controller 20 can be realized by a personal computer that executes a predetermined program, for example. As long as information can be input by a user with the input section 25, there is no particular limitation to it, and a mouse, a keyboard, a touch panel or the like may be used for it, for example.

As noted above, the seed LD is pulse-driven, and the excitation LDs are CW-driven. However, it is preferable that the controller 20 controls the drivers 21, 22, 23A and 23B in such a manner that if the non-emitting periods of the seed LD are long, then the output from the excitation LDs is interrupted during these non-emitting periods.

The characteristics of the seed LD, the excitation LDs, the isolator, the bandpass filter and so on may be temperature-dependent. Consequently, it is preferable to provide the laser processing device with a temperature controller for keeping the temperature of these elements constant.

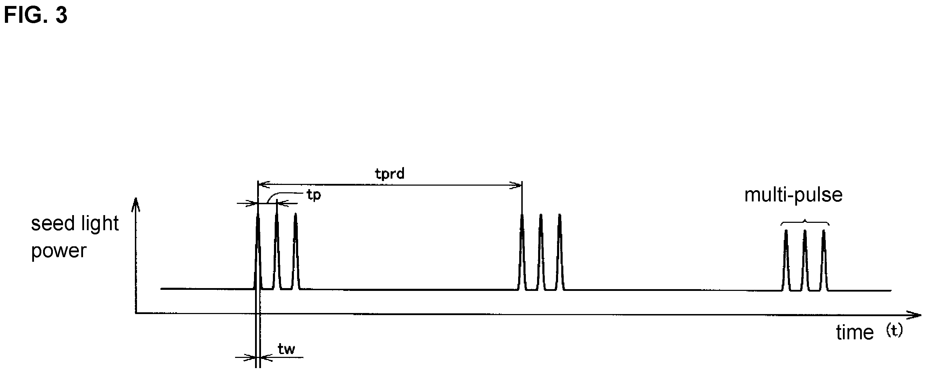

Fig. 3 is a diagram illustrating a waveform of the seed light according to the present embodiment. As shown in Fig. 3, during each repeating period tprd, a pulse train including a plurality of light pulses, that is, a multi-pulse, is output from the seed LD 2. The time interval (pulse interval) between the plurality of light pulses is tp.

The repeating period tprd and the pulse interval tp are set based on the processing conditions of the processing object, such as the material (metal, plastic or the like) of the processing object, the processing time, the processing quality, etc. The repeating period tprd may be selected from the range of 1 µs to 1 ms, for example. On the other hand, the pulse interval tp is shorter than the repeating interval tprd, and may be selected from the period of 1ns to 100 ns, for example.

Since the pulse interval tp is short, the scanning distance between one pulse and the next pulse in the pulse train constituting one multi-pulse is very short. Thus, the subsequent pulse is irradiated within the range of the processing trace on the surface of the processing object due to the previous pulse, and as a result, the processing trace due to the pulse train constituting one multi-pulse is formed continuously on the surface of the processing object. That is to say, one multi-pulse constitutes one processing unit irradiated at substantially one location on the processing object.

In the waveform shown in Fig. 3, there are three light pulses included in the pulse train. However, the number of light pulses included in the pulse train is not particularly limited, as long as there are a plurality of them, and may be set as appropriate. Moreover, the repeating period tprd is not limited to a fixed value and may also be varied.

The laser processing device according to this embodiment of the invention employs a MOPA (Master Oscillator and Power Amplifier) system using a light-amplifying fiber, and uses light from a semiconductor laser as the seed light. The seed light emitted from the seed LD 2 is amplified by the optical fibers 1 and 8, and is output from the laser processing device 100. The seed LD 2 outputs a pulse train including a plurality of light pulses as the seed light, so that pulse trains including a plurality of light pulses, or in other words, laser light with multi-pulses is output from the laser processing device 100.

Driving the seed LD 2 with the driver 21, the seed LD 2 generates seed light (a pulse train). By controlling the current supplied to the seed LD 2 with the driver 21, a plurality of parameters, such as the repeating period tprd of the seed light (pulse train) emitted from the seed LD 2, the number of pulses included in the pulse train, the pulse interval tp, the peak power (amplitude of the pulses) of the light pulses, and the pulse width of the light pulses, can be controlled independently from each other. The laser light that is output from the laser processing device 100 is seed light amplified by the optical fibers 1 and 8. By controlling the parameters relating to the seed light, a plurality of parameters relating to the laser light (pulse train) output from the laser processing device 100 (such as the number of pulses included in the pulse train, the repeating period, the pulse interval, the peak power (amplitude of the pulses) of the light pulses, and the pulse width of the light pulses) can be controlled independently from each other.

Thus, with this embodiment of the invention, it is possible to output pulse trains (multi-pulses) as the laser light from the laser processing device 100. Moreover, it is possible to independently control a plurality of parameters relating to the laser light (pulse train) that is output from the laser processing device 100. Consequently, with this embodiment of the invention, it is possible to output laser light (pulse trains) for performing the desired processing from the laser processing device 100.

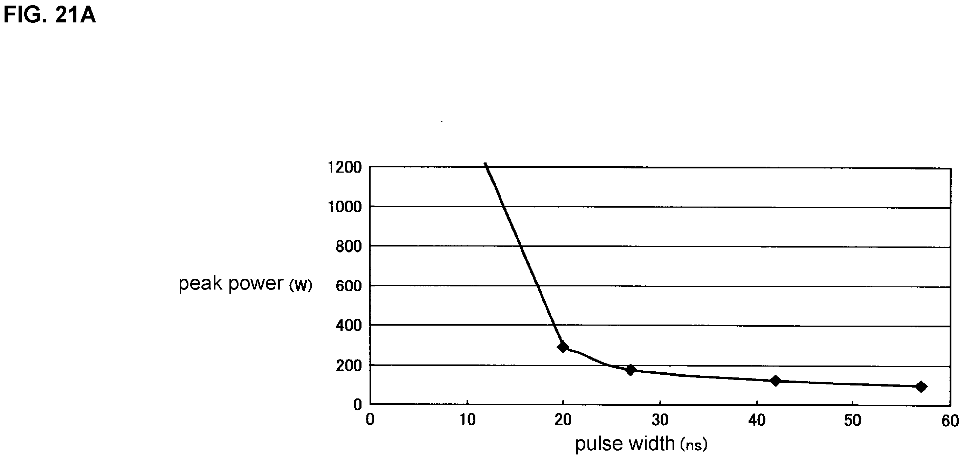

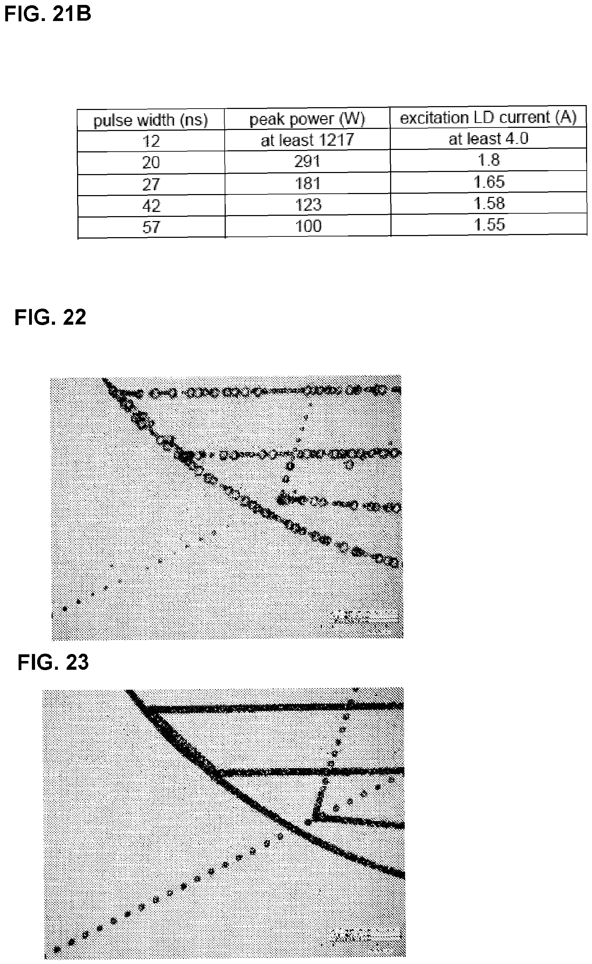

Here, the result of experimentally obtaining preferable values of the pulse width (full-width at half maximum) tw of the light pulses is shown in Figs. 21A and 21B.

Fig. 21A is a diagram showing, as a graph, the relationship between the pulse width of the seed light and the peak power (the SBS threshold) of the amplified light when the seed light is amplified as much as possible without generating stimulated Brillouin scattering (SBS). Fig. 21B is a diagram showing, as a table, the relationship between the pulse width of the amplified light, the peak power, and the drive current of the excitation LDs. As shown in Figs. 21A and 21B, at a pulse width of 20 ns or less, the SBS threshold (peak power) increases sharply. Thus, it is preferable that the pulse width of the individual light pulses is not greater than 20 ns.

Fig. 22 is a diagram showing the result of printing on the surface of metal with light pulses emitted from a laser amplifier, during the occurrence of SBS. Fig. 23 is a diagram showing the result of printing on a metal surface with laser light (pulse train) emitted from the laser processing device under the condition that there is no SBS, in accordance with the embodiment. As shown in Figs. 22 and 23, when there is SBS, the size of the spots formed on the metal surface is irregular, and also the pitch of the spots is irregular. It seems that this is because the energy of the light pulses emitted from the laser amplifier is not stable due to the SBS, and the incident light is reflected almost completely and does not enter the medium. On the other hand, with the present embodiment, the pulse width can be easily set to the condition that there is no SBS, so that spots of regular size are formed at regular pitch on the metal surface. Consequently, high-quality processing becomes possible when processing metal surfaces (when printing text or graphics on a metal surface, for example).

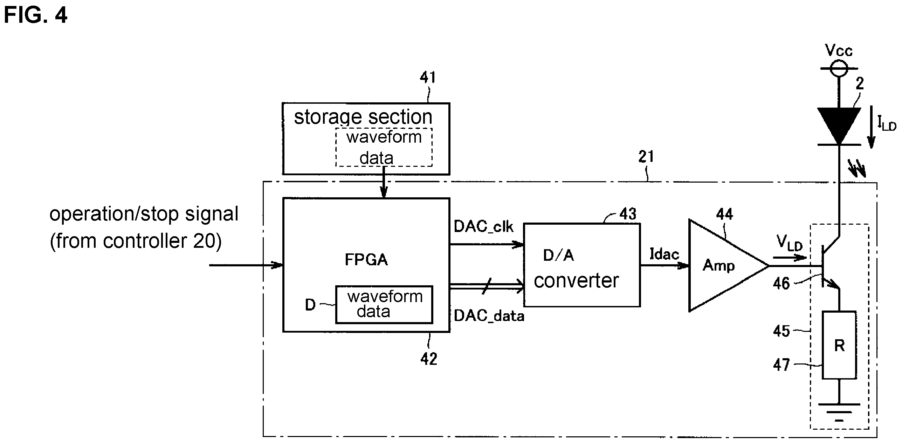

Fig. 4 is a diagram showing an example of the configuration of the driver 21 driving the seed LD 2 shown in Fig. 1. As shown in Fig. 4, the driver 21 includes an FPGA (Field Programmable Gate Array) 42, a D/A converter 43, an amplifier (denoted as "Amp" in the figure) 44, and a driving section 45. The driving section 45 includes a transistor 46 and a resistor 47.

A storage section 41 stores, in a non-volatile manner, waveform data (digital data) defining the waveform of the seed light. The FPGA 42 is a digital signal generator that outputs the waveform data D read out from the storage section 41 as digital data. When the FPGA 42 receives an operation signal from the controller 20 (Fig. 1), it reads out the waveform data D from the storage section 41, and outputs a clock signal DAC_clk and a data signal DAC_data (digital data) based on this waveform data D. The FPGA 42 stops the operation in accordance with a stop signal from the controller 20.

Note that it is also possible that the waveform data is stored in the controller 20 and the FPGA 42 reads out the waveform data from the controller 20. Also, the FPGA 42 may store the waveform data in advance.

The D/A converter 43 receives the clock signal DAC_clk and the data signal DAC_data, and converts the digital data given by the data signal DAC_data into analog data. It is preferable that the D/A converter 43 is a D/A converter that is suitable for high-speed signal processing (high-speed D/A converter).

The amplifier 44 converts the current Idac, which is the analog signal from the D/A converter 43, into a signal that is necessary for the control of the transistor 46. A voltage V_{LD} that corresponds to the signal that is output from the amplifier 44 is given to the control electrode of the transistor 46.

When the transistor 46 becomes conductive in response to the voltage V_{LD}, a drive current I_{LD} flows through the seed LD 2. When the drive current I_{LD} becomes larger than a threshold current, the seed LD 2 begins a laser oscillation and seed light is emitted from the seed LD 2. The current flowing through the transistor 46 is controlled by the voltage V_{LD}, thus controlling the intensity of the drive current I_{LD}. Thus, the intensity of the seed light is controlled.

It is preferable that the driver 21 is constituted such that data of a plurality of waveforms can be selected depending on the application. The data for the plurality of waveforms may be stored inside the storage section 41 or inside the controller 20, for example. Moreover, the digital signal generator is not limited to an FPGA, and may be a microprocessor or an ASIC (Application Specific Integrated Circuit) or the like.

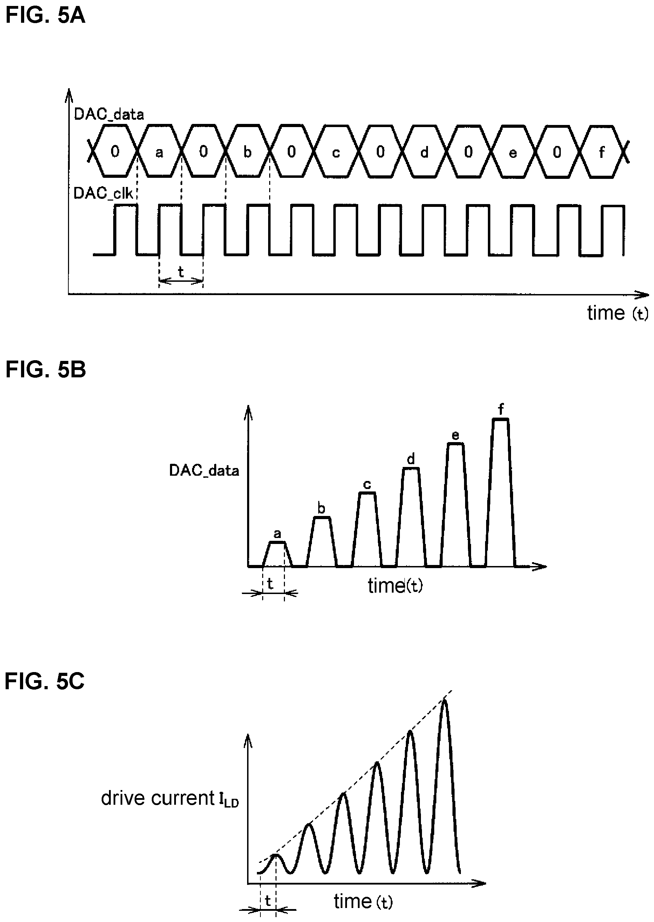

Figs. 5A and 5B are diagrams illustrating the operation of the driver 21 having the configuration shown in Fig. 4. Figs. 5A and 5B are diagrams showing the output timing of the digital data that is output from the FPGA 42 shown in Fig. 4.

Fig. 5C is a waveform diagram of the drive current I_{LD} shown in Fig. 4.

As shown in Figs. 5A to 5C and in Fig. 4, the input value that is input into the D/A converter 43 (the value indicated by the data signal DAC_data) is set to zero and a certain value (one of the values a to f in Figs. 5A and 5B). In response to a rising flank or a falling flank of the clock signal DAC_clk having the period t, the D/A converter 43 reads in the digital data indicated by the data signal DAC_data and converts the digital data that has been read in into analog data. As shown in Fig. 5A, a "0" is inserted as an input value between any one of the input values a to f (for example "a") and the next value (for example "b").

As shown in Fig. 5B, the input values a to f that are input into the D/A converter 43 increase steadily from a to f. The D/A converter 43, the amplifier 44 and the driving section 45 operate in accordance with the input value. Depending on their responsiveness, the peak value of the drive current I_{LD} changes and becomes larger over time, as shown in Fig. 5C.

It should be noted that the periods during which the value of the data signal DAC_data is zero (corresponding to the period t) correspond to the pulse interval tp shown in Fig. 3. Moreover, as shown in Fig. 5A, the FPGA 42 changes the value of the data signal DAC_data in order from a to f for every repeating period tprd, for example. Thus, every repeating period tprd, a pulse train can be generated by the seed LD 2.

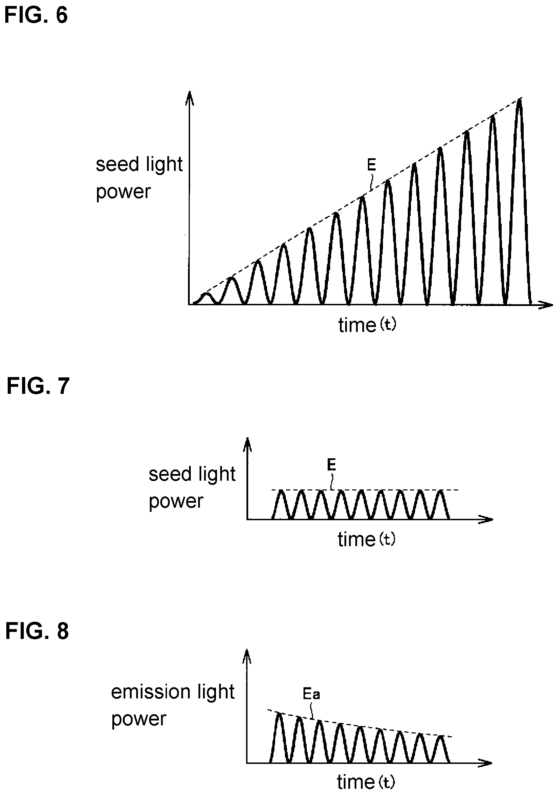

Fig. 6 is a diagram showing the waveform of the seed light that is output from the seed LD by supplying the drive current I_{LD} having the waveform shown in Fig. 5C to the seed LD. As shown in Fig. 6, the envelope E of the seed light waveform increases monotonically with respect to time (t). As long as it increases monotonically with respect to time, the envelope E may be a straight line or a curved line. By controlling the intensity of the seed light such that the envelope of the seed light waveform increases monotonically over time, the intensity of the pulses included in the pulse train output from the laser processing device can be controlled to be constant.

Fig. 7 is a diagram showing a waveform of the seed light where the peak of the plurality of light pulses constituting a multi-pulse is controlled to be constant. As shown in Fig. 7, the envelope E of the waveform of the seed light is a straight line whose slope with respect to time is 0.

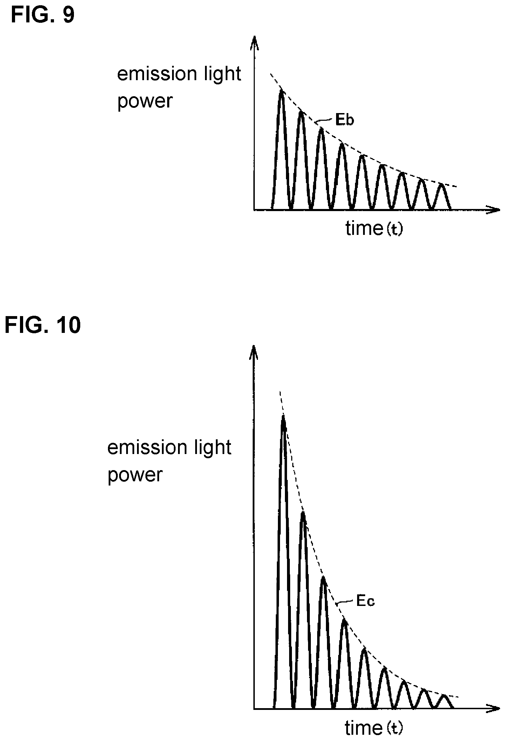

Figs. 8 to 10 are diagrams showing waveforms of emission light (pulse trains) emitted from the light-amplifying fiber by amplifying the seed light having the waveform shown in Fig. 7 with the light-amplifying fiber. Fig. 8 is a diagram showing the waveform of the emission light (pulse train) for the case that the degree of amplification of the light-amplifying fiber is small. Fig. 9 is a diagram showing the waveform of the emission light (pulse train) for the case that the degree of amplification of the light-amplifying fiber is medium. Fig. 10 is a diagram showing the waveform of the emission light (pulse train) for the case that the degree of amplification of the light-amplifying fiber is large. It should be noted that the degree of amplification of the light-amplifying fiber is set in correspondence with the power of the excitation light that is coupled into the light-amplifying fiber.

Figs. 8 to 10 show envelopes (Ea to Ec) of the waveform of the plurality of light pulses emitted from the light-amplifying fiber. As can be seen from the shapes of the envelopes Ea to Ec, the peak power of the emitted light pulses drops steadily, regardless of the degree of amplification of the optical fiber. The reason for this is that when the pulse train is coupled into the light-amplifying fiber, the plurality of light pulses included in the pulse train are amplified successively, and thus the energy accumulated in the core (the rare-earth atoms) gradually attenuates. The larger the energy accumulated in the core (the rare-earth atoms) is, the larger the degree of amplification of the light-amplifying fiber becomes, and the larger the degree of attenuation of the peak power of the light pulses amplified by the light-amplifying fiber becomes. Consequently, if the envelope E of the seed light pulses is linear, the shape of the envelope E changes considerably in accordance with the degree of amplification of the light-amplifying fiber.

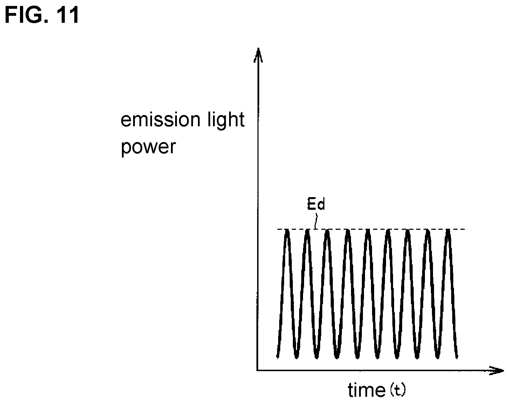

As shown in Fig. 6, by letting the envelope E of the seed light pulses increase monotonically over time, the drop of the peak power of the emitted light due to the drop in the degree of amplification of the light-amplifying fiber can be corrected. As a result, it is possible to stabilize the peak power of the emission light, as shown in Fig. 11, so that the envelope Ed of the emission light waveform can be made a straight line whose slope with respect to time is substantially zero.

It should be noted that Fig. 6 shows an example of the seed light waveform. The shape of the envelope of the plurality of light pulses may be a predetermined shape with which the processing conditions desired by the user can be satisfied. Consequently, the envelope may be a straight line or a curve following a predetermined function, or the like.

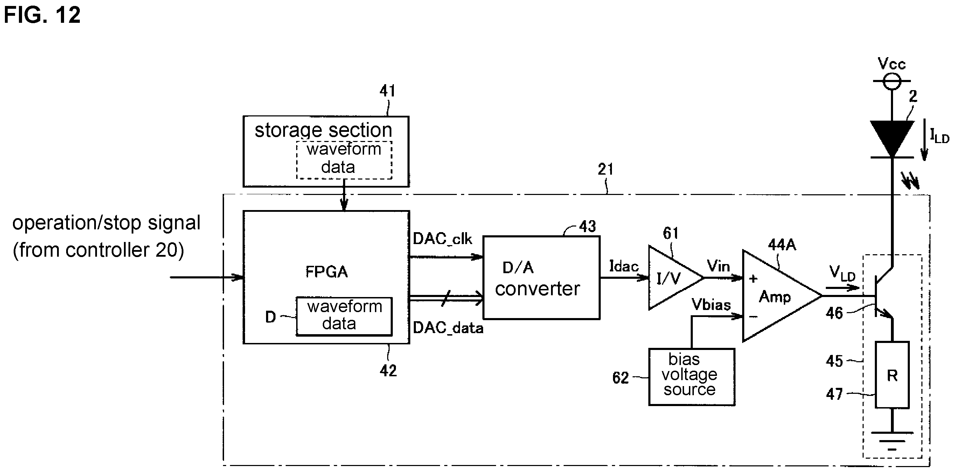

Fig. 12 is a diagram showing another example of a configuration of a driver 21 driving the seed LD 2 shown in Fig. 1. As shown in Fig. 12, the configuration of the driver 21 differs from the configuration shown in Fig. 4 with regard to the following aspects. First of all, the driver 21 includes a current-voltage converter (I/V) 61 that converts the current Idac output from the D/A converter 43 into a voltage Vin, and a bias voltage source 62 that generates a bias voltage Vbias. Furthermore, the driver 21 includes an operational amplifier 44A instead of the amplifier 44.

If the voltage Vin is larger than the bias voltage Vbias, then the operational amplifier 44A generates a voltage V_{LD} corresponding to (Vin - Vbias). The bias voltage source 62 is constituted for example by a D/A converter. The bias voltage source 62 can be set to the desired voltage Vbias by external control (for example by the controller 20). More specifically, the bias voltage source 62 generates a voltage Vbias in correspondence to data that is input into the bias voltage source 62. By controlling the voltage Vbias, it is possible to control the voltage V_{LD} applied to the control electrode of the transistor 46 and the drive current I_{LD} supplied to the seed LD 2.

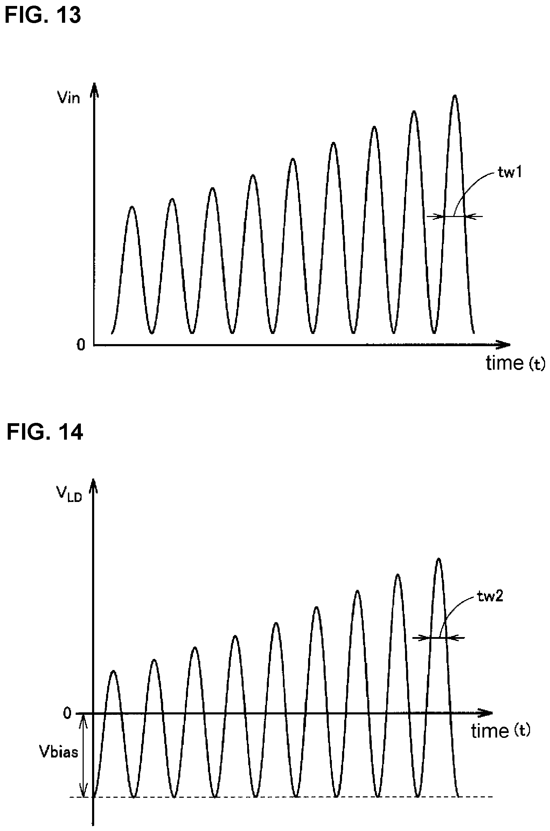

Fig. 13 is a waveform diagram of the voltage Vin shown in Fig. 12. As shown in Fig. 13, the width (full width at half maximum) of one voltage pulse is tw1.

By inputting the voltage Vin and the voltage Vbias into the operational amplifier 44A, the level of the voltage Vin drops by Vbias in negative direction. Thus, the level of the voltage V_{LD} is shifted to the negative direction.

Fig. 14 is a waveform diagram of the voltage V_{LD} that is controlled by the driver 21 shown in Fig. 12. As shown in Figs. 14 and 12, the pulse width of the voltage V_{LD} becomes tw2 (tw2 < tw1). That is to say, through the level shift of the voltage V_{LD}, the pulse width of the voltage V_{LD} becomes smaller.

By making the pulse width of the voltage V_{LD} smaller, the pulse width of the drive current I_{LD} becomes smaller. And by making the pulse width of the drive current I_{LD} smaller, the pulse width of each of the plurality of light pulses included in the seed light (pulse train) emitted from the seed LD 2 becomes smaller. Consequently, it is possible to shorten the pulse width of each of the plurality of light pulses included in the pulse train that is output from the laser processing device. It should be noted that other parameters, such as the repeating period tprd, can be controlled independently of the pulse width of the plurality of light pulses. Consequently, it is possible to change only the pulse width of the light pulses while maintaining the repeating period tprd, for example.

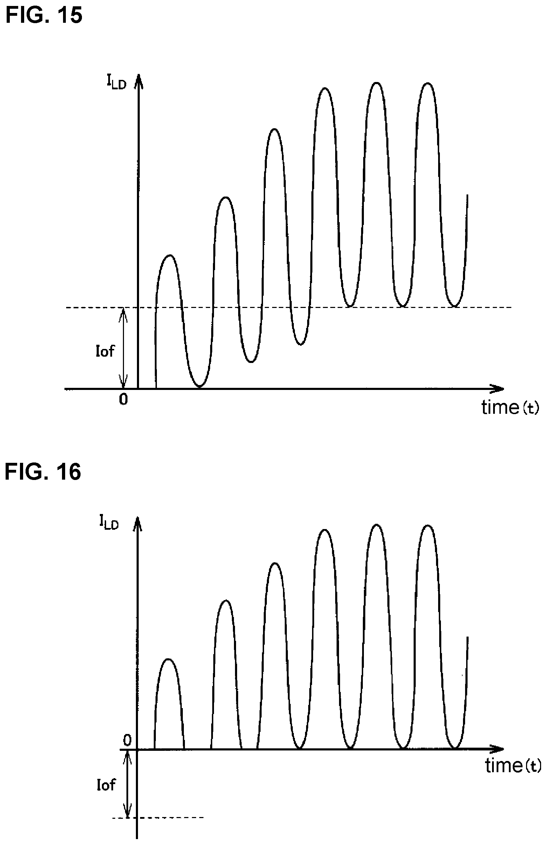

Fig. 15 is a waveform diagram of the current I_{LD} for the case that the voltage Vbias is zero and the period of the voltage V_{LD} is short. As shown in Fig. 16, due to such reasons as the response of the transistor 46, when the period of the voltage V_{LD} becomes short, an offset component occurs in the current I_{LD}.

Fig. 16 is a waveform diagram of the current I_{LD} for the case that the voltage Vbias is set to a predetermined value. As shown in Fig. 16, it is possible to shift the level of the current I_{LD} with the voltage Vbias by a current I_{of} that corresponds to the offset component of the current I_{LD}. That is to say, it is possible to reduce the offset component of the current I_{LD}. Thus, even when an offset component is included in the seed light, this offset component can be made small.

With the configuration of Fig. 12, the amplitude of the seed light waveform is changed by changing the pulse width of the voltage V_{LD}. However, the power of the laser light (pulse train) that is amplified by the light-amplifying fiber is controlled by the power of the excitation light. Consequently, with the laser processing device according to this embodiment of the present invention, the amplitude of the seed light waveform may be changed. By controlling the power of the excitation light, it is possible to control the power of the laser light (the peak power of each of the plurality of light pulses included in the pulse train) that is output from the laser processing device.

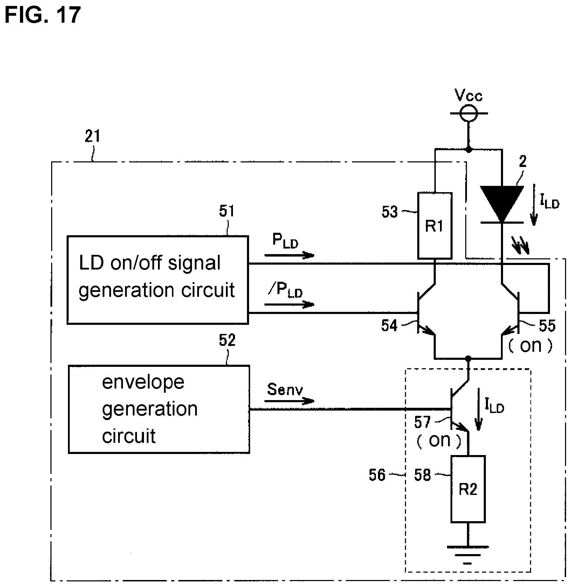

Fig. 17 is a diagram showing yet another example of a configuration of the driver 21 driving the seed LD 2. As shown in Fig. 17, the driver 21 has a similar circuit configuration as the input section of a differential amplifier. More specifically, the driver 21 includes an LD on/off signal generation circuit 51, an envelope generation circuit 52, a resistor 53, transistors 54 and 55, and a constant current circuit section 56. The constant current circuit section 56 includes a transistor 57 and a resistor 58.

The LD on/off signal generation circuit 51 outputs a control signal PLD for controlling the transistor 54 and a control signal /PLD for controlling the transistor 55. The control signals PLD and /PLD are complementary signals. The transistor 55 is connected in series to the seed LD 2.

The envelope generation circuit 52 outputs a signal Senv for controlling the constant current circuit section 56 (transistor 57).

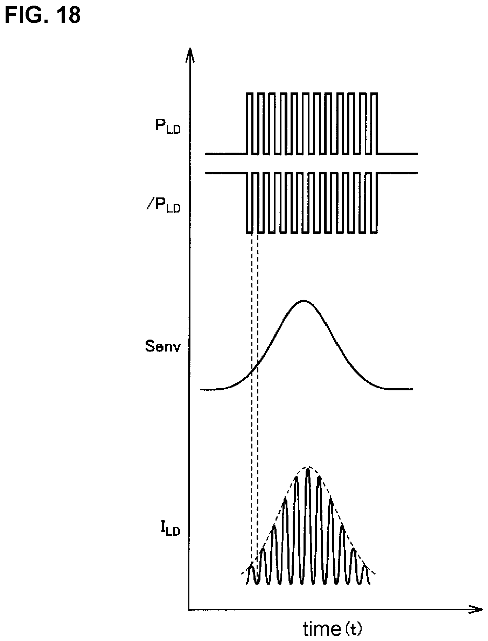

Fig. 18 is a diagram illustrating the operation of the driver 21 having the configuration shown in Fig. 17. As shown in Figs. 18 and 17, since the control signals PLD and /PLD are complementary signals, the transistors 54 and 55 are alternately turned on. Consequently, the transistor 55 is turned on at every predetermined repeating period. Furthermore, the current flowing through the transistor 57 is controlled in accordance with the signal Senv. Thus, the current flowing through the constant current circuit section 56 is controlled. That is to say, the control signals PLD and /PLD are specifically for realizing that predetermined conditions under which stimulated Brillouin scattering occurs due to any of the plurality of light pulses included in the group of light pulses can be suppressed can be specifically realized by the driver 21 having the configuration shown in Fig. 17.

When the transistor 55 is on, the drive current ILD flows through the current path made of the seed LD 2, the transistor 55 and the constant current circuit section 56. The size of this current is determined by the signal Senv. Since the transistor 55 is turned on every predetermined repeating period, the drive current ILD becomes a pulsed current. By setting the waveform of the signal Senv to the desired waveform with the envelope generation circuit 52, the waveform of the signal Senv can be reflected by the shape of the envelope of the waveform of the drive current ILD. Thus, the waveform of the signal Senv is reflected by the shape of the envelope of the intensity waveform of the seed light that is output from the seed LD 2. It should be noted that the waveform of the signal Senv is not limited to the waveform shown in Fig. 18, and can be set to any suitable waveform.

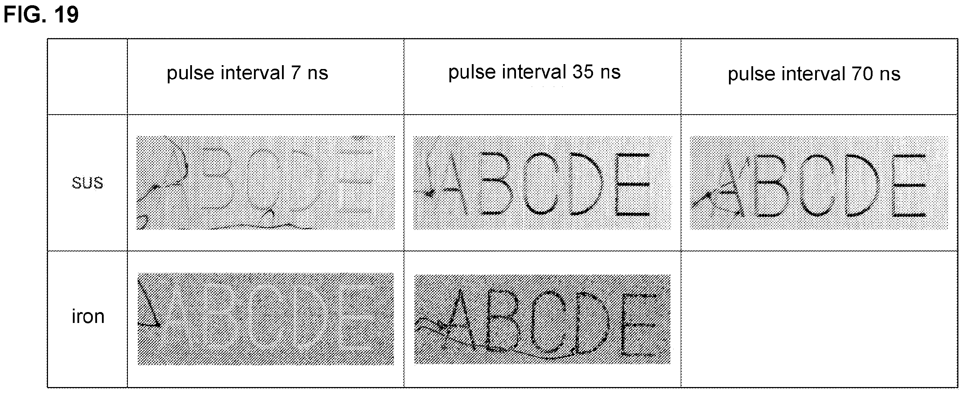

Fig. 19 is a diagram showing an example of the result of a processing experiment performed with the laser processing device according to this embodiment of the present invention. As shown in Fig. 19, in this experiment, letters were printed on the surface of SUS (stainless steel) and iron, while changing the pulse interval tp of the seed light (pulse train) between 7ns, 35 ns and 70 ns. It should be noted that in this experiment, only the pulse interval tp of the seed light was changed. By making the pulse interval longer, the processing state of the SUS can be changed, and as a result it is possible to change the printing color from white to black.

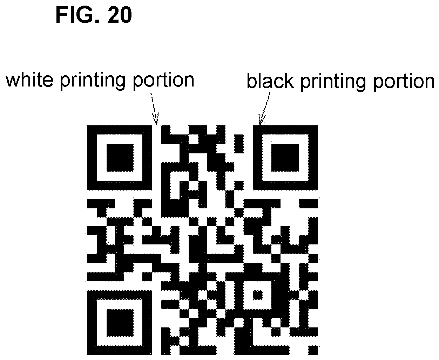

As shown in Fig. 19, the color of the text pattern changes from white to black as the pulse interval tp is changed. Consequently, by changing the pulse interval tp in accordance with the processing location while scanning once with the laser light, it is possible to produce a black and white pattern on the surface of the processing object. By applying such a method for producing a black and white pattern, it is possible to produce a two-dimensional code that includes both a white printing portion and a black printing portion, as shown in Fig. 20 for example, with a single surface process. The code shown in Fig. 20 is the symbol string of a "QR Code" (registered trademark).

If a two-dimensional code as shown in Fig. 20 is produced on the surface of a processing object (such as one made of metal) with a conventional processing method, then, first of all, processing is performed to make the entire surface of the processing object white, and then processing for forming a black pattern is performed next. By contrast, if the laser processing device according to this embodiment of the present invention is used, then the data relating to the parameters of the seed light (waveform data of the seed light) is prepared in advance. The driver 21 drives the seed LD 2 in accordance with this data. Furthermore, the laser beam scanning mechanism 14 scans in two-dimensional directions with the seed light that has been amplified by the optical fibers 1 and 8. Thus, it is possible to produce a pattern including both a white printing portion and a black printing portion with a single surface process. Consequently, with this embodiment of the present invention, it is possible to achieve an improved cycle time.

With the embodiments of the present invention as described above, it is possible to output a pulse train (laser light turned into a multi-pulse) from the laser processing device 100 by repeatedly generating pulse trains including a plurality of light pulses from the seed LD 2 with a predetermined period. If a method is used in which a single light pulse is divided into a plurality of light pulses and these light pulses are combined in order to output a pulse train from the laser processing device, then it is necessary to provide light paths of different lengths for each of the light pulses and to perfectly match the optical axis of the light pulses. Therefore, the laser processing device becomes large and its configuration becomes complex. However, with the embodiments of the present invention, instead of using such a method, the laser light (pulse train) for the desired processing can be output from the laser processing device, so that it can be avoided that the laser processing device becomes large, and it can be avoided that its configuration becomes complex.

Furthermore, with the embodiments of the present invention, the driver 21 drives the seed LD 2 based on the wavelength data. By changing the wavelength data, a plurality of parameters relating to the seed light (pulse train) can be changed independently from one another, so that the degree of freedom for controlling the seed light (pulse train) can be increased. Thus, the degree of freedom for controlling the laser light (pulse train) that is output from the laser processing device can be increased.

For example, as shown in Figs. 19 and 20, it is possible to realize the desired processing by changing only one parameter out of the plurality of parameters relating to the seed light, and maintaining all other parameters. Furthermore, with the embodiments of the present invention, it is also possible to realize the desired processing by changing a desired number of parameters selected from the plurality of parameters relating to the seed light. As noted above, the change of these parameters can be realized by changing the waveform data used for the driver 21.

It should be noted that with the embodiments of the present invention, the seed LD 2 generates a pulse train including a plurality of light pulses at a predetermined period, by driving the seed LD 2 with the driver 21 using the waveform data. However, the method for generating a pulse train including a plurality of light pulses from the seed light source at a predetermined period is not limited to that explained above. For example, it is also, but not in accordance with the invention, possible to generate the pulse train including the plurality of light pulses as seed light by turning continuous light generated by a seed light source on and off with a shutter. By repeating the on- and off-state of the shutter, it is possible to generate a pulse train including a plurality of light pulses. Furthermore, by making the period during which the pulse train is generated longer than the on/off period of the shutter, it is possible to generate the pulse train including the plurality of light pulses with a predetermined period, and to make the time interval between the plurality of light pulses shorter than the predetermined period. Also in this case, the time interval between the plurality of light pulses and the period with which the pulse train is generated can be controlled independently, while preventing the device from becoming big and its configuration from becoming complex.

The embodiments disclosed herein are meant to be in all aspects illustrative and not limiting. The scope of the invention is defined by the appended claims, rather than by the above explanations.

### INDEX TO THE REFERENCE NUMERALS

1, 8 ... optical fiber, 2 ... seed LD, 3, 9A, 9B ... excitation LD, 4, 6, 11 ... isolator, 5, 10 ... coupler, 7 ... band-pass filter, 12 ... end cap, 14 ... laser beam scanning mechanism, 20 ... controller, 21, 22, 23A, 23B ... driver, 25 ... input section, 31, 35 ... core, 32 ... cladding, 36 ... first cladding, 37 ... second cladding, 34, 38 ... jacket, 41 ... storage section, 42 ... FPGA, 43 ... D/A converter, 44 ... amplifier, 44A ... operational amplifier, 45 ... driving section, 46, 54, 55, 57 ... transistor, 47, 53, 58 ... resistor, 50 ... processing object, 51 ... LD on/off signal generation circuit, 52 ... envelope generation circuit, 56 ... constant current circuit section, 61 ... current-voltage converter, 62 ... bias voltage source, 100 ... laser processing device, E, Ea - Ed ... envelope, L ... laser light.

## Claims

1. A laser processing device (100) comprising:
a seed light source (2) emitting seed light;
an excitation light source (3, 9A, 9B) emitting excitation light; and
a light-amplifying fiber (1, 8) arranged such that the seed light is amplified by coupling the seed light and the excitation light into it;
wherein the seed light source (2) is configured to repeatedly generate, as the seed light, pulse trains including a plurality of light pulses, the seed light source generating the pulse trains with a predetermined period;
a time interval (tp) between the plurality of light pulses is shorter than an interval (tprd) between the pulse trains; and
a number, a pulse width, an amplitude and an interval of the light pulses are controllable independently from each other,
wherein the amplitude of the light pulse is changed according to a processing condition so that an envelope (E) of a waveform of each pulse train increases strictly monotonically with respect to time,
wherein the seed light source (2) comprises a semiconductor laser; and
the laser processing device further comprises a drive circuit (21) driving the semiconductor laser using changeable waveform data (D) defining the waveform of the pulse train, the drive circuit comprising:
a storage section (41) for storing the waveform data;
a digital signal generator (42) for reading out the waveform data from the storage unit and outputting, based on the waveform data, a clock signal (DAC_clk) and a data signal (DAC_data) containing digital data; and
a digital/analog converter (43) configured to receive the clock signal and the data signal from the digital signal generator and configured to convert the data indicated by the data signal into an analog signal (Idac) in synchronization with the clock signal, wherein the analog signal (Idac) controls a drive current (ILD) that is supplied to the seed light source (2), and the drive current (ILD) controls intensity of the emitted seed light.

2. The laser processing device according to claim 1, wherein the plurality of light pulses is irradiated at substantially the same location of a processing object (50).

3. The laser processing device according to claim 1, wherein the pulse width of the light pulses is not greater than 20 ns.

4. The laser processing device according to claim 1, wherein the drive circuit (21) comprises:
an amplifier (44) that amplifies the analog signal from the digital/analog converter (43); and
a transistor (46) that controls the drive current (I_{LD}) that is supplied to the semiconductor laser in response to the analog signal amplified by the amplifier (44).

5. The laser processing device according to claim 1, wherein the drive circuit (21) comprises:
a current/voltage converter (61) that converts the analog signal (I_{dac}) into a voltage signal;
a bias voltage source (62) that generates a bias voltage (Vbias);
a differential amplifier (44A) that generates a signal (V_{LD}) corresponding to a difference between a voltage of the voltage signal and the bias voltage; and
a transistor (46) that controls the drive current (I_{LD}) that is supplied to the semiconductor laser in response to the signal that is generated by the differential amplifier (44A),
wherein the analog signal (Idac) is a current signal.

6. The laser processing device according to claim 5, wherein the bias voltage source (62) generates the bias voltage corresponding to the data input into the bias voltage source (62).

7. A laser processing method with a laser processing device (100) comprising a seed light source (2) emitting seed light, an excitation light source (3, 9A, 9B) emitting excitation light, a light-amplifying fiber (1, 8) arranged such that the seed light is amplified by coupling the seed light and the excitation light into it, and a scanning mechanism (14) for scanning with the light emitted from the light-amplifying fiber (1, 8); the method comprising:
a step of repeatedly generating, with a predetermined period, as the seed light, pulse trains comprising a plurality of light pulses, from the seed light source (2);
a step of forming a desired pattern on a surface of a processing object (50), by irradiating the processing object (50) with the emission light from the light-amplifying fiber (1, 8) using the scanning mechanism (14);
wherein a time interval (tp) between the plurality of light pulses is shorter than an interval (tprd) between the pulse trains;
a step of setting a number, a pulse width, an amplitude and an interval of the light pulses wherein the number, the pulse width, the amplitude and the interval of the light pulses are controllable independently from each other;
in the step of generating the seed light, the interval of the light pulses is changed depending on the processing location of the processing object (50) and the amplitude of the light pulse is changed according to a processing condition so that an envelope (E) of a waveform of each pulse train increases strictly monotonically with respect to time,
wherein the seed light source (2) comprises a semiconductor laser; and
the laser processing device further comprises a drive circuit (21);
a step of driving the semiconductor laser using waveform data (D) defining the waveform of the pulse train;
a step of storing the waveform data;
a step of reading out the waveform data and outputting, based on the waveform data, a clock signal (DAC_clk) and a data signal (DAC_data) containing digital data; and
a step of receiving the clock signal and the data signal and converting the digital data indicated by the data signal into an analog signal (Idac) in synchronization with the clock signal; and
a step of controlling the analog signal (Idac) to control a drive current (ILD) that is supplied to the seed light source (2), wherein the drive current (ILD) controls intensity of the emitted seed light.

## Patentansprüche

1. Laserbearbeitungsvorrichtung (100), umfassend:
eine Seed-Lichtquelle (2), die Seed-Licht emittiert;
eine Anregungslichtquelle (3, 9A, 9B), die Anregungslicht emittiert; und
eine lichtverstärkende Faser (1, 8), die derart angeordnet ist, dass das Seed-Licht durch Einkoppeln des Seed-Lichts und des Anregungslichts in die lichtverstärkende Faser (1, 8) verstärkt wird;
wobei die Seed-Lichtquelle (2) geeignet ist, wiederholt Impulsserien mit mehreren Lichtimpulsen als das Seed-Licht zu erzeugen, wobei die Seed-Lichtquelle die Impulsserien mit einer vorbestimmten Periode erzeugt;
ein Zeitintervall (tp) zwischen den mehreren Lichtimpulsen kürzer als ein Intervall (tprd) zwischen den Impulsserien ist; und
eine Anzahl, eine Impulsbreite, eine Amplitude und ein Intervall der Lichtimpulse unabhängig voneinander steuerbar sind,
wobei die Amplitude des Lichtimpulses entsprechend einer Bearbeitungsbedingung so verändert wird, dass eine Hüllkurve (E) einer Wellenform jeder Impulsserie streng monoton in Bezug auf Zeit zunimmt,
wobei die Seed-Lichtquelle (2) einen Halbleiterlaser umfasst; und
die Laserbearbeitungsvorrichtung ferner eine Antriebsschaltung (21) aufweist, die den Halbleiterlaser unter Verwendung von veränderbaren Wellenformdaten (D), die die Wellenform der Impulsserien definieren, ansteuert, wobei die Ansteuerungsschaltung aufweist:
einen Speicherabschnitt (41) zum Speichern der Wellenformdaten;
einen Digitalsignalerzeuger (42) zum Auslesen der Wellenformdaten aus der Speichereinheit und zum Ausgeben, basierend auf den Wellenformdaten, eines Taktsignals (DAC_clk) und eines Datensignals (DAC_data), das digitale Daten enthält; und
einen Digital/Analog-Wandler (43), der geeignet ist, das Taktsignal und das Datensignal von dem Digitalsignalerzeuger zu empfangen, und der geeignet ist, die durch das Datensignal angegebene Daten synchron mit dem Taktsignal in ein Analogsignal (Idac) umzuwandeln, wobei das Analogsignal (Idac) einen Antriebsstrom (ILD) ansteuert, der der Seed-Lichtquelle (2) zugeführt wird, und der Antriebsstrom (ILD) die Intensität des emittierten Seed-Lichts ansteuert.

2. Laserbearbeitungsvorrichtung nach Anspruch 1, wobei die mehreren Lichtimpulse im Wesentlichen auf die gleiche Stelle eines Bearbeitungsobjektes (50) eingestrahlt werden.

3. Laserbearbeitungsvorrichtung nach Anspruch 1, wobei die Impulsbreite der Lichtimpulse nicht größer als 20 ns ist.

4. Laserbearbeitungsvorrichtung nach Anspruch 1, wobei die Antriebsschaltung (21) umfasst:
einen Verstärker (44), der das Analogsignal von dem Digital/AnalogWandler (43) verstärkt; und
einen Transistor (46), der den Antriebsstrom (ILD), der dem Halbleiterlaser zugeführt wird, in Antwort auf das vom Verstärker (44) verstärkte Analogsignal ansteuert.

5. Laserbearbeitungsvorrichtung nach Anspruch 1, wobei die Antriebsschaltung (21) umfasst:
einen Strom/Spannungs-Wandler (61), der das analoge Signal (Idac) in ein Spannungssignal umwandelt;
eine Vorspannungsquelle (62), die eine Vorspannung (Vbias) erzeugt;
einen Differentialverstärker (44A), der ein Signal (VLD) erzeugt, das einer Differenz zwischen einer Spannung des Spannungssignals und der Vorspannung entspricht; und
einen Transistor (46), der den Antriebsstrom (ILD), der dem Halbleiterlaser zugeführt wird, in Antwort auf das Signal, das vom Differenzverstärker (44A) erzeugt wird, ansteuert,
wobei das Analogsignal (Idac) ein Stromsignal ist.

6. Laserbearbeitungsvorrichtung nach Anspruch 5, wobei die Vorspannungsquelle (62) die Vorspannung erzeugt, die den in der Vorspannungsquelle (62) eingegebenen Daten entspricht.

7. Laserbearbeitungsverfahren mit einer Laserbearbeitungsvorrichtung (100) umfassend eine Seed-Lichtquelle (2), die Seed-Licht emittiert, eine Anregungslichtquelle (3, 9A, 9B), die Anregungslicht emittiert, eine lichtverstärkende Faser (1, 8), die derart angeordnet ist, dass das Seed-Licht durch Einkoppeln des Seed-Lichts und des Anregungslichts in die lichtverstärkende Faser (1, 8) verstärkt wird, und einen Abtastmechanismus (14) zum Abtasten mit dem von der lichtverstärkenden Faser (1, 8) emittierten Licht; wobei das Verfahren umfasst:
einen Schritt zum wiederholten Erzeugen, mit einer vorbestimmten Periode, von Impulsserien mit mehreren Lichtimpulsen als das Seed-Licht, von der Seed-Lichtquelle (2);
einen Schritt zum Bilden eines gewünschten Musters auf einer Oberfläche eines Bearbeitungsobjekts (50) durch Bestrahlen des Verarbeitungsobjekts (50) mit dem Emissionslicht von der lichtverstärkenden Faser (1, 8) unter Verwendung des Abtastmechanismus (14);
wobei ein Zeitintervall (tp) zwischen den mehreren Lichtimpulsen kürzer als ein Intervall (tprd) zwischen den Impulsserien ist;
einen Schritt zum Einstellen einer Anzahl, einer Impulsbreite, einer Amplitude und eines Intervalls der Lichtimpulse, wobei die Anzahl, die Impulsbreite, die Amplitude und das Intervall der Lichtimpulse unabhängig voneinander steuerbar sind;
wobei in dem Schritt zum Erzeugen des Seed-Lichts das Intervall der Lichtimpulse in Abhängigkeit von der Bearbeitungsstelle des Bearbeitungsobjekts (50) verändert wird, und die Amplitude des Lichtimpulses gemäß einer Bearbeitungsbedingung so verändert wird, dass eine Hüllkurve (E) einer Wellenform jeder Impulsserie streng monoton in Bezug auf Zeit zunimmt,
wobei die Seed-Lichtquelle (2) einen Halbleiterlaser umfasst; und
die Laserbearbeitungsvorrichtung ferner eine Antriebsschaltung (21) umfasst;
einen Schritt des Ansteuerns des Halbleiterlasers unter Verwendung von Wellenformdaten (D), die die Wellenform der Impulsserie definieren;
einen Schritt zum Speichern der Wellenformdaten;
einen Schritt zum Auslesen der Wellenformdaten und zum Ausgeben, basierend auf den Wellenformdaten, eines Taktsignals (DAC_clk) und eines Datensignals (DAC_data), das digitale Daten enthält; und
einen Schritt zum Empfangen des Taktsignals und des Datensignals und zum Umwandeln der durch das Datensignal angegebenen digitalen Daten in ein analoges Signal (Idac) synchron mit dem Taktsignal; und
einen Schritt zum Ansteuern des Analogsignals (Idac), um einen Antriebsstrom (ILD) anzusteuern, der der Seed-Lichtquelle (2) zugeführt wird, wobei der Antriebsstrom (ILD) die Intensität des emittierten Seed-Lichts ansteuert.

## Revendications

1. Dispositif de traitement laser (100) comprenant :
une source de lumière d'amorçage (2) émettant une lumière d'amorçage ;
une source de lumière d'excitation (3, 9A, 9B) émettant une lumière d'excitation ; et
une fibre amplificatrice de lumière (1, 8) disposée de telle sorte que la lumière d'amorçage est amplifiée en y couplant la lumière d'amorçage et la lumière d'excitation ;
dans lequel la source de lumière d'amorçage (2) est configurée pour générer de manière répétée, comme lumière d'amorçage, des trains d'impulsions comprenant plusieurs impulsions de lumière, la source de lumière d'amorçage générant les trains d'impulsions avec une période prédéterminée ;
un intervalle de temps (tp) entre les plusieurs impulsions lumineuses est plus court qu'un intervalle (tprd) entre les trains d'impulsions ; et
un nombre, une largeur d'impulsion, une amplitude et un intervalle des impulsions lumineuses sont contrôlables indépendamment les uns des autres,
dans lequel l'amplitude de l'impulsion lumineuse est modifiée en fonction d'une condition de traitement de sorte qu'une enveloppe (E) d'une forme d'onde de chaque train d'impulsions augmente de façon strictement monotone par rapport au temps,
dans lequel la source de lumière d'amorçage (2) comprend un laser semi-conducteur ; et
le dispositif de traitement laser comprend en outre un circuit de direction (21) qui dirige le laser semi-conducteur en utilisant des données de forme d'onde modifiable (D) définissant la forme d'onde du train d'impulsions, le circuit de direction comprenant :
une section de stockage (41) pour stocker les données de forme d'onde :
un générateur de signal numérique (42) pour lire les données de forme d'onde de l'unité de stockage et sortir, sur la base des données de forme d'onde, un signal d'horloge (DAC_clk) et un signal de données (DAC_data) contenant des données numériques ; et
un convertisseur numérique/analogique (43) configuré pour recevoir le signal d'horloge et le signal de données du générateur de signal numérique et configuré pour convertir les données indiquées par le signal de données en un signal analogique (Idac) en synchronisation avec le signal d'horloge, dans lequel le signal analogique (Idac) commande un courant de direction (ILD) fourni à la source de lumière d'amorçage (2), et le courant de direction (ILD) commande l'intensité de la lumière d'amorçage émise.

2. Dispositif de traitement laser selon la revendication 1, dans lequel les plusieurs impulsions de lumière sont irradiée sensiblement au même endroit d'un objet de traitement (50).

3. Dispositif de traitement laser selon la revendication 1, dans lequel la largeur d'impulsion des impulsions de lumière n'est pas supérieure à 20 ns.

4. Dispositif de traitement laser selon la revendication 1, dans lequel le circuit de direction (21) comprend :
un amplificateur (44) qui amplifie le signal analogique provenant du convertisseur numérique/analogique (43) ; et
un transistor (46) qui contrôle le courant de direction (ILD) qui est fourni au laser semi-conducteur en réponse au signal analogique amplifié par l'amplificateur (44).

5. Dispositif de traitement laser selon la revendication 1, dans lequel le circuit de direction (21) comprend :
un convertisseur courant/tension (61) qui convertit le signal analogique (Idac) en un signal de tension ;
une source de tension de polarisation (62) qui génère une tension de polarisation (Vbias) ;
un amplificateur différentiel (44A) qui génère un signal (VLD) correspondant à une différence entre une tension du signal de tension et la tension de polarisation ; et
un transistor (46) qui contrôle le courant de direction (ILD) fourni au laser semi-conducteur en réponse au signal généré par l'amplificateur différentiel (44A),
dans lequel le signal analogique (Idac) est un signal de courant.

6. Dispositif de traitement laser selon la revendication 5, dans lequel la source de tension de polarisation (62) génère la tension de polarisation correspondant aux données entrées dans la source de tension de polarisation (62).

7. Procédé de traitement laser avec un dispositif de traitement laser (100) comprenant une source de lumière d'amorçage (2) émettant une lumière d'amorçage, une source de lumière d'excitation (3, 9A, 9B) émettant une lumière d'excitation, une fibre amplificatrice de lumière (1, 8) disposée de telle sorte que la lumière d'amorçage est amplifiée en y couplant la lumière d'amorçage et la lumière d'excitation, et un mécanisme de balayage (14) pour balayer avec la lumière émise par la fibre amplificatrice de lumière (1, 8) ; le procédé comprenant :
une étape consistant à générer de manière répétée, avec une période prédéterminée, des trains d'impulsions comprenant plusieurs impulsions de lumière comme lumière d'amorçage, à partir de la source de lumière d'amorçage (2) ;
une étape consistant à former un motif souhaité sur une surface d'un objet de traitement (50) en irradiant l'objet de traitement (50) avec la lumière d'émission provenant de la fibre amplificatrice de lumière (1, 8) en utilisant le mécanisme de balayage (14) ;
dans lequel un intervalle de temps (tp) entre la pluralité d'impulsions de lumière est plus court qu'un intervalle (tprd) entre les trains d'impulsions ;
une étape consistant à définir un nombre, une largeur d'impulsion, une amplitude et un intervalle des impulsions de lumière, dans lequel le nombre, la largeur d'impulsion, l'amplitude et l'intervalle des impulsions de lumière peuvent être commandés indépendamment les uns des autres ;
dans l'étape de génération de la lumière d'amorçage, l'intervalle des impulsions lumineuses est modifié en fonction du lieu de traitement de l'objet à traiter (50) et l'amplitude de l'impulsion lumineuse est modifiée en fonction d'une condition de traitement de sorte qu'une enveloppe (E) d'une forme d'onde de chaque train d'impulsions augmente de manière strictement monotone par rapport au temps,
dans lequel la source de lumière d'amorçage (2) comprend un laser semi-conducteur ; et
le dispositif de traitement laser comprend en outre un circuit de direction (21) ;
une étape de direction du laser semi-conducteur utilisant des données de forme d'onde (D) définissant la forme d'onde du train d'impulsions ;
une étape de stockage des données de forme d'onde ;
une étape de lecture des données de forme d'onde et de sortie, sur la base des données de forme d'onde, d'un signal d'horloge (DAC_clk) et d'un signal de données (DAC_data) contenant des données numériques ; et
une étape de réception du signal d'horloge et du signal de données et de la conversion des données numériques indiquées par le signal de données en un signal analogique (Idac) en synchronisation avec le signal d'horloge ; et
une étape de contrôle du signal analogique (Idac) pour contrôler un courant de direction (ILD) fourni à la source de lumière d'amorçage (2), dans laquelle le courant de direction (ILD) contrôle l'intensité de la lumière d'amorçage émise.
